# EUROPEAN PATENT SPECIFICATION

(11) **EP 0 448 047 B1**
(45) Date of publication and mention of the grant of the patent: **01.02.1995**
(21) Application number: 91104246.3
(22) Date of filing: 19.03.1991
(51) Int. Cl.: H03K 19/017, H03K 17/04, H03F 3/30

(54) **Field effect transistor circuit**
Feld-Effekt-Transistorschaltung
Circuit à transistor à effet de champ

(30) Priority: 19.03.1990 JP 69304/90; 12.03.1991 JP 46964/91
(43) Date of publication of application: 25.09.1991
(73) Proprietor: KABUSHIKI KAISHA TOSHIBA, Kawasaki-shi, Kanagawa-ken 210 (JP)
(72) Inventor: Kataoka, Shigeru, 106, Joyful Shinmaruko Daini, Nakahara-ku, Kawasaki-shi, Kanagawa-ken (JP)
(74) Representative: Lehn, Werner, Dipl.-Ing.

(56) References cited:
- GB-A- 2 001 197
- US-A- 4 792 705
- PATENT ABSTRACTS OF JAPAN vol. 9, no. 106 (E-313)(1829)10 May 1985 JP-A-59 231 917 ( HITACHI SEISAKUSHO ) 26 December 1984

## Description

### BACKGROUND OF THE INVENTION

This invention relates to a field effect transistor circuit, and more particularly to a push-pull circuit suitable for an output stage of a semiconductor integrated circuit.

For an output stage of a semiconductor integrated circuit, a push-pull circuit comprised of two field effect transistors of the same characteristic is frequently used.

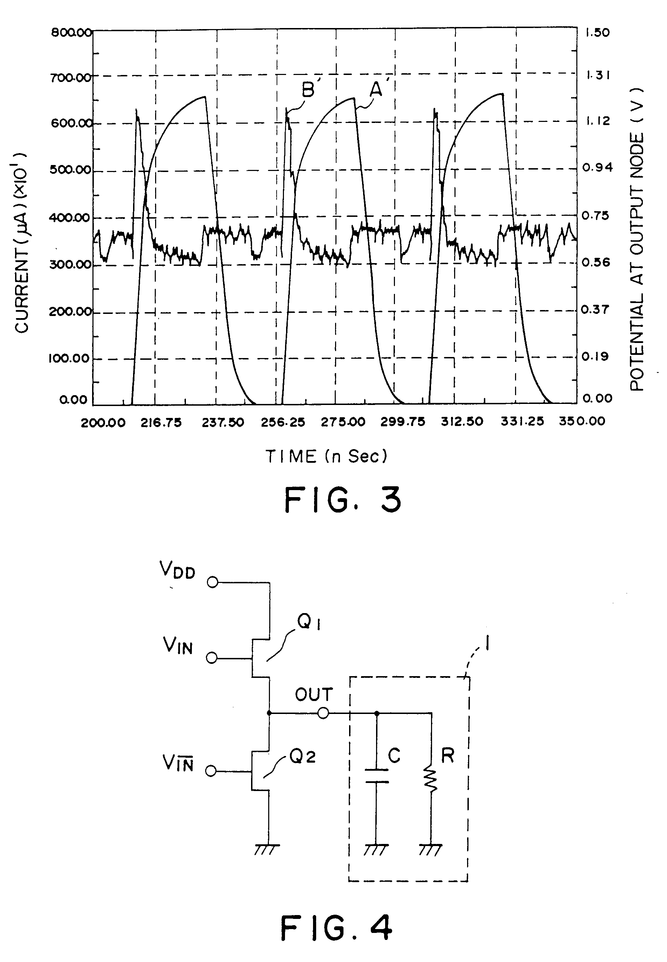

FIG. 4 is a circuit diagram showing an example of a typical push-pull circuit used in DCFL (Direct Coupled FET Logic) circuits, etc. Between the positive power supply (V_{DD}) and ground, two field effect transistors Q₁ and Q₂ are connected in series. A positive input signal V_{IN} is applied to the gate electrode of the transistor Q₁, and an inverted input signal V̅_̅{̅I̅N̅}̅ is applied to the gate electrode of the transistor Q₂. The drain of the transistor Q₁ is connected to the positive power supply, and the source of the transistor Q₂ is grounded to take out an output signal V_{OUT} from the output point OUT which is a connection node of the source of the transistor Q₁ and the drain of the transistor Q₂. A load 1 for simulating the operation including a capacitor C and a resistor R connected in parallel is connected to the output point OUT. This load 1 has, e.g., a capacitance value of 10 pF and a resistance value of 100 KΩ.

In this cirucit, when V_{IN} is at L (low) level and V̅_̅{̅I̅N̅}̅ shifts to H (high) level, the transistors Q₁, and Q₂ are turned OFF and ON, respectively. Accordingly, charges stored in the capacitor C are discharged as a drain current I_{d} through the transistor Q₂. Thus, a potential V_{OUT} on the output point is lowered, resulting in L level. In contrast, when V_{IN} is at H level and V̅_̅{̅I̅N̅}̅ shifts to L level, the transistors Q₁ and Q₂ are turned ON and OFF, respectively. Thus, a drain current I_{d} flows to charge the capacitor C. As a result, a potential on the output point is raised, resulting in H level.

However, with such a circuit configuration, since the gate-source voltage (V_{GS}) of the transistor Q₁ is lowered as V_{OUT} rises, the drain current I_{d} is lowered, resulting in a lowered load drivability.

Accordingly, when transistors having completely the same characteristics are used as the transistors Q₁ and Q₂ in FIG. 4, the rise performance to shift from L level to H level is inferior to the fall performance to shift from H level to L level.

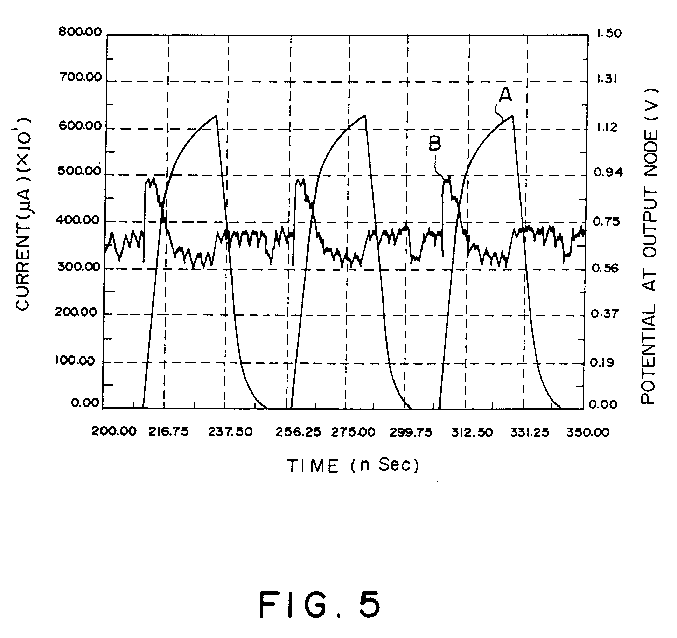

FIG. 5 is a graph showing the relationship between an output voltage (waveform A) and a current consumption (waveform B) in such a conventional push-pull circuit wherein the abscissa represents a time (nano second). As seen from this figure a current when the output voltage rises is to such an extent that it increases from 350 »A of an ordinary value to 500 »A. Therefore, it cannot be said that a sufficient current is delivered. Namely, it cannot be said that the voltage rises steeply, resulting in insufficient load drivability.

### SUMMARY OF THE INVENTION

Accordingly, an object of this invention is to provide a field effect transistor circuit constituting a push-pull circuit of an excellent load drivability.

According to this invention, there is provided a field effect transistor circuit comprising first and second field effect transistors formed on the same substrate, the first transistor having a drain connected to a positive voltage power supply and a gate adapted so that an input signal is inputted thereto, the second transistor having a drain connected to a source of the first field effect transistor, a gate adapted so that an inverted signal of the input signal is inputted thereto, and a source connected to ground, the junction of the both transistors being caused to serve as an output point to which a load is connected, characterized in that the gate width of the first field effect transistor is caused to be larger than the gate width of the second field effect transistor.

This invention is characterized in that there are provided two field effect transistors constituting a push-pull circuit formed on the same semiconductor substrate, wherein the drain of a first field effect transistor for delivering a current to a load of the two field effect transistors is connected to a power supply, the gate width of the first transistor being caused to be larger than the gate width of a second field effect transistor for discharging charges from the load.

Thus, a drain current at the time of rise can be increased, resulting in an improved load drivability.

### BRIEF DESCRIPTION OF THE DRAWINGS

In the accompanying drawings,
FIG. 1 is a perspective view showing a partial cross section of a semiconductor device according to an embodiment of this invention,
FIG. 2 is a circuit diagram showing the configuration of a circuit to which this invention is applied,
FIG. 3 is a graph showing an improvement in the load drivability according to this invention,
FIG. 4 is a circuit diagram showing the configuration of a conventional typical push-pull circuit, and
FIG. 5 is a graph showing a conventional load drivability.

### DESCRIPTION OF THE PREFERRED EMBODIMENT

A preferred embodiment of this invention will now be described with reference to the attached drawings.

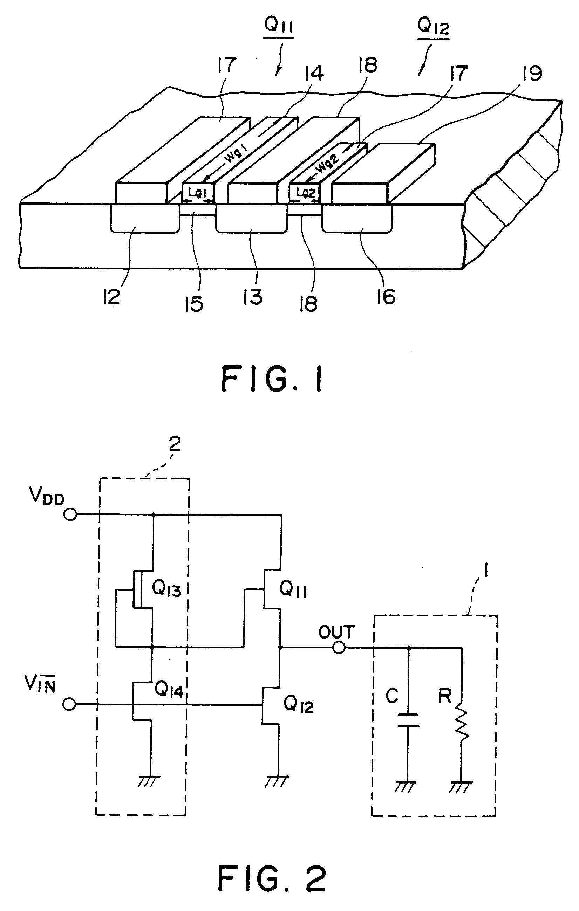

FIG. 2 is a circuit diagram showing an actual circuit configuration. In this circuit, an inverter 2 comprised of transistors Q₁₃ and Q₁₄ connected in series is provided at the preceding stage of two transistors Q₁₁ and Q₁₂ connected in series constituting a push-pull circuit. Namely, the drain of the transistor Q₁₁ is connected to a positive power supply (V_{DD}), the source of the transistor Q₁₁ and the drain of the transistor Q₁₂ are connected, and the source of the transistor Q₁₂ is grounded. Further, the source of the depletion type transistor Q₁₃ is connected to the positive power supply (V_{DD}), the source of the enhancement transistor Q₁₄ is connected to the drain of the transistor Q₁₃, and the drain of the transistor Q₁₄ is grounded. The gate of the transistor Q₁₃ is connected to the drain thereof, and the junction thereof is connected to the gate of the transistor Q₁₁. Further, the gate of the transistor Q₁₄ and the gate of the transistor Q₁₂ are commonly connected, thus constituting a signal input point V̅_̅{̅I̅N̅}̅. In addition, the junction of the drain of the transistor Q₁₁ and the source of the transistor Q₁₂ serves as an output point OUT. A load 1 including a capacitor C and a resistor R connected in parallel is connected to the output point OUT. This load 1 has, e.g., a capacitance value of 10 pF and a resistance value of 100 KΩ.

FIG. 1 is a perspective view showing a partial cross section of a device structure according to an embodiment of this invention. In this embodiment, a field effect transistor comprised of a chemical compound semiconductor using a Ga-As semi-insulting substrate of the III-V group is taken as an example, but it is to be noted that transistors used are not limited to this transistor.

This figure represents the structure at the semiconductor substrate surface of transistors Q₁₁ and Q₁₂. The transistor Q₁₁ is of a structure such that impurity diffused regions 12 and 13 thereof are opposite to each other through a channel region 15 below a gate electrode 14. Further, the transistor Q₁₂ is of a structure such that impurity diffused regions 13 and 16 thereof are opposite to each other through a channel region 18 below a gate electrode 17. These impurity diffused regions 12, 13 and 16 are drawn out to the external for electrical connection by means of electrode wirings 17, 18 and 19 formed by gold-germanium alloy, etc., respectively. In this embodiment, the impurity diffused region 12 serves as the drain of the transistor Q₁₁, the impurity diffused region 13 serves as the source of the transistor Q₁₁ and the drain of the transistor Q₁₂, and the impurity diffused region 16 serves as the source of the transistor Q₁₂.

Here, the gate electrode 14 of the transistor Q₁₁ has a gate length L_{g1} substantially equal to the channel length and a gate width W_{g1}, in a direction perpendicular thereto. Further, the gate electrode 17 of the trandsistor Q₁₂ has a gate length L_{g2} substantially equal to the channel length and a gate width W_{g2} in a direction perpendicular thereto. In this example, both gate lengths L_{g1} and L_{g2} are equal to each other, and are equal to, e.g., 0.8 »m. On the contrary, the relationship expressed as W_{g1}/W_{g2} > 1 holds in connection with the width of the gate electrode. For example, the gate width W_{g1} is 30 »m and the gate width W_{g2} is 15 »m. The relationship expressed as W_{g1}/W_{g2} = 2 > 1 holds.

The operation of this circuit will now be described. An input signal V̅_̅{̅I̅N̅}̅ is applied to the gate of the transistor Q₁₂ as it is. Further, an inverted input signal V_{IN} provided by inverting the input signal V_{IN} by means of an inverter 2 is applied to the gate of the transistor Q₁₁. Thus, an output signal is taken out from the output point OUT serving as the junction of the drain of the transistor Q₁₁ and the source of the transistor Q₁₂.

Since an inverted signal of the input signal V_{IN} is at L level when the signal V̅_̅{̅I̅N̅}̅ shifts to H level, the transistors Q₁₁ and Q₁₂ are turned OFF and ON, respectively. As a result, charges stored in the capacitor C is discharged as a drain current I_{d} through the transistor Q₁₂. Thus, the potential of the output V_{OUT} is lowered, resulting in L level. In contrast, when the input signal V̅_̅{̅I̅N̅}̅ is at L level and an inverted signal thereof shifts to H level, the transistors Q₁₁ and Q₁₂ are turned ON and OFF, respectively. As a result, a drain current I_{d} flows to charge the capacitor C. Thus, the potential of the output V_{OUT} is raised, resulting in H level. At this time, since the gate electrode width of the transistor Q₁₁ is larger than the gate electrode width of the transistor Q₁₂, the drain current becomes an extremely large value.

The above-mentioned circumstances are shown in FIG. 3. The current waveform B′ indicates that a current value at the time of rise is larger 1.1 times or more than that in the case of the prior art. As a result, it is seen that the output potential waveform A′ rises more steeply than in the conventional case shown in FIG. 5, and the load drivability is therefore improved to more degree as compared to the prior art. Namely, as the output voltage V_{OUT} rises, the gate-source voltage (V_{GS}) of the transistor Q₁₁ is lowered. However, since a sufficient drain current I_{d} flows at the initial stage, satisfactory characteristic at the time of rise is provided.

It is to be noted that it is meaningless to vary the gate length in such an improvement in the rise characteristic. The reason therefor is as follows. Since it is clear that according as the gate length becomes short, the gate capacity becomes small, and the characteristic is improved to greater degree as the gate capacity becomes small, it is sufficient that all transistors have a short gate length without having to purposely vary the gate length.

While an inverter is used as the means for forming an inverted signal in the above-described embodiment, it is a matter of course that any logic gates may be used as long as they have the function of inverting the logic.

As described above, in accordance with this invention, there are provided two field effect transistors connected in series to employ a dimensional relationship such that the gate width of one transistor for allowing a charge current to the load to flow of the above-mentioned two transistors is larger than the gate width of the other transistor for allowing a discharge current from the load to flow. Thus, a charge current to the load when a signal rises can become large, resulting in an improved load drivability.

Reference signs in the claims are intended for better understanding and shall not limit the scope.

## Claims

1. A field effect transistor circuit comprising first and second field effect transistors (Q₁₁, Q₁₂) formed on the same substrate, said first transistor having a drain connected to a positive voltage power supply and a gate adapted so that an input signal is inputted thereto, said second transistor having a drain connected to a source of said first field effect transistor, a gate adapted so that an inverted signal of said input signal is inputted thereto, and a source connected to ground, the junction of said both transistors being caused to serve as an output point to which a load is connected,
characterized in that the gate width (W_{g1}) of said first field effect transistor (Q₁₁) is caused to be larger than the gate width (W_{g2}) of said second field effect transistor (Q₁₂).

2. A field effect transistor circuit as set forth in claim 1, wherein said load is comprised of a capacitor and a resistor connected in parallel.

3. A field effect transistor circuit as set forth in claim 2, wherein an inverter for forming said inverted signal is provided at the preceding stage of said circuit.

## Patentansprüche

1. Feldeffekttransistorschaltung mit einem ersten und einem zweiten Feldeffekttransistor (Q₁₁, Q₁₂), die auf dem gleichen Substrat gebildet sind, wobei der erste Transistor einen Drain aufweist, der an eine Leistungsversorgung positiver Spannung angeschlossen ist, und der ein Gatter aufweist, das so angepaßt ist, daß ein Eingangssignal daran angelegt wird, wobei der zweite Transistor aufweist: einen Drain, der an die Source des ersten Feldeffekttransistors angeschlossen ist; ein Gatter, das so angepaßt ist, daß daran ein invertiertes Signal des Eingangssignals angelegt wird; und eine mit Erde verbundene Source, wobei der Übergang beider Transistoren als ein Ausgangspunkt dient, an den eine Last angeschlossen wird;
dadurch **gekennzeichnet**, daß die Gatterbreite (W_{g1}) des ersten Feldeffekttransistors (Q₁₁) größer als die Gatterbreite (W_{g2}) des zweiten Feleffekttransistors (Q₁₂) ist.

2. Feldeffekttransistorschaltung nach Anspruch 1, bei der die Last aus einem Kondensator und einem Widerstand in Parallelschaltung besteht.

3. Feldeffekttransistor nach Anspruch 2, bei dem ein Inverter zum Bilden des invertierten Signals an der vorhergehenden Stufe der Schaltung vorgesehen ist.

## Revendications

1. Circuit à transistors à effet de champ comprenant un premier et un second transistors à effet de champ (Q₁₁, Q₁₂) constitués sur le même substrat, ledit premier transistor ayant son drain connecté à une source d'alimentation de tension positive et sa grille adaptée de façon qu'un signal d'entrée y soit appliqué, ledit second transistor ayant son drain connecté à la source dudit premier transistor à effet de champ, sa grille adaptée de façon qu'un signal inverse dudit signal d'entrée y soit appliqué, et sa source connectée à la masse, la jonction desdits deux transistors étant faite pour servir de point de sortie auquel est connectée une charge,
caractérisé en ce que la largeur de la grille (W_{g1}) dudit premier transistor à effet de champ (Q₁₁) soit rendue plus grande que la largeur de la grille (W_{g2}) dudit second transistor à effet de champ (Q₁₂).

2. Circuit à transistors à effet de champ selon la revendication 1, dans lequel ladite charge est constituée d'un condensateur et d'une résistance connectés en parallèle.

3. Circuit à transistors à effet de champ selon la revendication 2, dans lequel un inverseur destiné à constituer ledit signal inverse est prévu dans l'étage qui précède ledit circuit.
